Europäisches Patentamt

European Patent Office

Office européen des brevets

(11) Publication number: **0 160 441**
A1

# (12) EUROPEAN PATENT APPLICATION

(21) Application number: 85302559.1

(22) Date of filing: 11.04.85

(51) Int. Cl.⁴: **G 01 R 31/08**

(30) Priority: 24.04.84 US 603484

(43) Date of publication of application:
06.11.85 Bulletin 85/45

(84) Designated Contracting States:
AT BE CH DE FR GB IT LI NL SE

(71) Applicant: RAYCHEM CORPORATION
300 Constitution Drive
Menlo Park California 94025(US)

(72) Inventor: Frank, Louis M.
1532 Cormorant Court
Sunnyvale California(US)

(72) Inventor: Bonomi, Mauro
2965 Alexis Drive
Palo Alto California 94304(US)

(74) Representative: Benson, John Everett et al,
Raychem Limited Intellectual Property Law Department
Swan House 37-39, High Holborn
London WC1(GB)

(54) Apparatus and method for detecting and locating information about an event.

(57) A method and apparatus for detecting and locating an event, i.e. a change in a variable, for example an increase in the concentration of a fluid as a result of a leak, a change in the physical position of a moveable member such as a valve, a change in temperature, or a change in pressure. The apparatus includes an elongate locating member (L) to which connection is made at the location of the event (E), and second and third members (S, R) to supply current to, and to measure the voltage drop down, the locating member (L). A reference impedance ($Z_R$) is connected in series with the locating member (L). When an event takes place, the voltage drop down, the locating member, from one end to the location of the event (E), and the voltage drop across the reference impedance are determined. A divider provides a ratio between the voltage drops and the location of the event is determined from that ratio. In this way, variations in the size of the current down the locating member (L) do not have an adverse effect on the accuracy of the location.

FIG—1

EP 0 160 441 A1

0160441
MP0932

DESCRIPTION

APPARATUS AND METHOD FOR DETECTING
AND LOCATING INFORMATION ABOUT AN EVENT

This invention relates to methods and apparatus for detecting and obtaining information about (particularly locating) changes in variables.

Introduction to the Invention

A number of methods have been proposed for use to detect changes in variables along an elongate path, e.g. the occurrence of a leak (of water or another liquid or gas), insufficient or excessive pressure, too high or too low a temperature, the presence or absence of light or another form of electromagnetic radiation, or a change in the physical position of a movable member, e.g. a valve in a chemical process plant or a window in a building fitted with a burglar alarm system. Changes of this kind are referred to in this specification by the generic term "event". Reference may be made for example to U. S. Patents Nos. 1,084,910, 2,581,213, 3,248,646, 3,384,493, 3,800,216, and 3,991,413, U.K. Patent No. 1,481,850 and German Offenlegungschriften Nos. 3,001,150.0 and 3,225,742.

The application corresponding to U.S. Serial Nos. 509,897 and 599,047, describes an improved method and apparatus for monitoring for the occurrence of an event, and for detecting and obtaining information about the event upon its occurrence (i.e. as soon as it occurs or at some time after it has occurred). In that method, upon occurrence of the event, an electrical connection is made between a source member and a locating member of known impedance characteristics, the connection(s) being effective at a first point at which the event takes place (or whose location is defined by some other characteristic of the event). A current of known size is then driven through the electrical connection and down the locating member to a second point whose location is known. The voltage drop between the first and second points is measured and the location of the first point can then be determined.

The application corresponding to U.S. Serial No. 599,048 describes a system which is somewhat similar to that just described, but differs from it in that (a) the source member is connected to the locating member, so that current can pass through the locating member in the absence of an event, and, (b) upon occurrence of the event, electrical connection is made between the locating member and the return member.

The application corresponding to U.S. Serial Nos. 556,740 and 556,829 describes preferred ways of assembling the locating, return and source members in the two methods just described, at least one of the members having a wrapped configuration.

In the two methods just described, a key requirement is that a current of known size or magnitude is driven down the locating member. One way of fulfilling this requirement is to provide a current source which outputs a known and constant current. Another way is to monitor a varying current, e.g. by way of an ammeter, so that the current is known at all times.

-3-                    0160441

## SUMMARY OF THE INVENTION

We have now discovered that great benefits can be obtained, in the two systems just described, by providing a reference impedance connected in series with the locating member. When an event takes place, the voltage drop between the first and second points on the locating member, and the voltage drop across the reference impedance, are compared, and the location of the event is determined from that comparison. In this way, variations in the size of the current do not have an adverse effect on the accuracy of the location. This is important even when using a so-called "constant current" source, because such sources can fluctuate in amplitude, e.g. from +4% to -4% of a reference amplitude, particularly at the low currents, e.g. less than 12 milliamps, preferably 1 to 250 microamps, preferably employed in very long systems. When using a constant voltage source, the need for an ammeter is eliminated.

In one aspect, the invention provides a method for monitoring for the occurrence of an event, and for detecting and obtaining information about the event upon its occurrence, which method comprises providing a system in which, upon occurrence of the event,

(1) electrical connection is made between an electrically conductive locating member and an electrically conductive second member;

the connection to the locating member being effective at a first point whose location is defined by at least one characteristic of the event;

the making of the connection enabling the formation

of a test circuit which comprises that part of the locating member between the first point and a second point on the locating member having a known location, and in which an electrical current is transmitted between the first and second points on the locating member;

that part of the locating member between the first point and the second point being connected in series with a reference impedance which has a known impedance and the current through which has a known relationship with the current through that part of the locating member; and

the current, the reference impedance and the locating member being such that, by obtaining a ratio between a first voltage drop across the reference impedance and a second voltage drop between the first and second points on the locating member, the spatial relationship between the first and second points can be determined;

(2) the ratio of the first and second voltage drops is obtained; and

(3) information concerning the event is obtained from the ratio in step (2).

In another aspect, the invention comprises an apparatus for use in the method described above which comprises

(1) an elongate electrically conductive locating member whose impedance from one end to any point on the locating member defines the spatial relationship between that end and
that point;

(2)   an elongate electrically conductive second
      member;

(3)   an event-sensitive connection means which,
      upon occurrence of an event, effects electrical
      connection between the locating member and
      the second member, the connection being
      effective at a first point on the locating
      member which is defined by at least one
      characteristic of the event;

(4)   an electrically conductive third member;

(5)   a reference impedance which has a known
      impedence and which is connected in series
      with said locating member;

(6)   a power source which, at least when occurrence
      of an event causes electrical connection to
      be made between the locating and second
      members, causes a current to be transmitted
      (i) between the first point and a second
      point which is at one end of the locating
      member, and (ii) through said reference
      impedance;

(7)   a first voltage-measuring device for determining
      a first voltage drop across said reference
      impedance,

(8)   a second voltage-measuring device for determining

0160441

a second voltage drop between the first and second points; and

(9)   a divider which provides a ratio between said first and second voltage drops.

In another aspect, the present invention provides a device which is suitable for use in a method and apparatus as described above and which comprises

(1)   three terminals (A,B,C);

(2)   a reference impedance which has a known impedance and which is connected between terminals A and C;

(3)   a first voltage measuring device connected across said reference impedance;

(4)   a second voltage measuring device connected across terminals A and B; and

(5)   a divider which provides a ratio between said first and second voltage drops;

whereby, when

(1)   terminal A is connected to one end of an elongate electrically conductive locating member whose impedance from one end to any point on the locating member defines the spatial relationship between that end and that point;

(2)   terminal C is connected to a power source, the power source also being connected to an elongate electrically conductive source member which is adjacent the locating member and becomes connected thereto if, but only if, an event takes place, the connection being effective at a first point on the locating member which is defined by at least one characteristic of the event; and

(3) terminal B is connected to an electrically conductive return member, the return member also being connected to the far end of the locating member,

there is obtained an apparatus as defined above in which occurrence of an event effects connection between the source and locating members. The same device can be used in apparatus in which occurrence of an event effects connection between the return and locating members.

The term "divider" is used herein to denote any device which obtains from the measurements of the voltage drops the desired information about the event.

The device and apparatus of the invention preferably also contain a display which is activated by the divider when it provides a ratio between the first and second voltage drops.

The device can also usefully comprise a fourth terminal (D) to which, when the device is in use, the power supply and the source member are connected. The device can also

0160441
MP0932

contain a component which, when the device is connected to an external power supply, will modify the power in a desired way. The device can also contain a power source, and in this case, the terminal C, when the device is in use, is connected to the source member. The various components of the device can be mounted on a support member and covered by a housing, the terminals being exposed or the housing being removable to expose the terminals for connection.

## BRIEF DESCRIPTION OF THE DRAWINGS

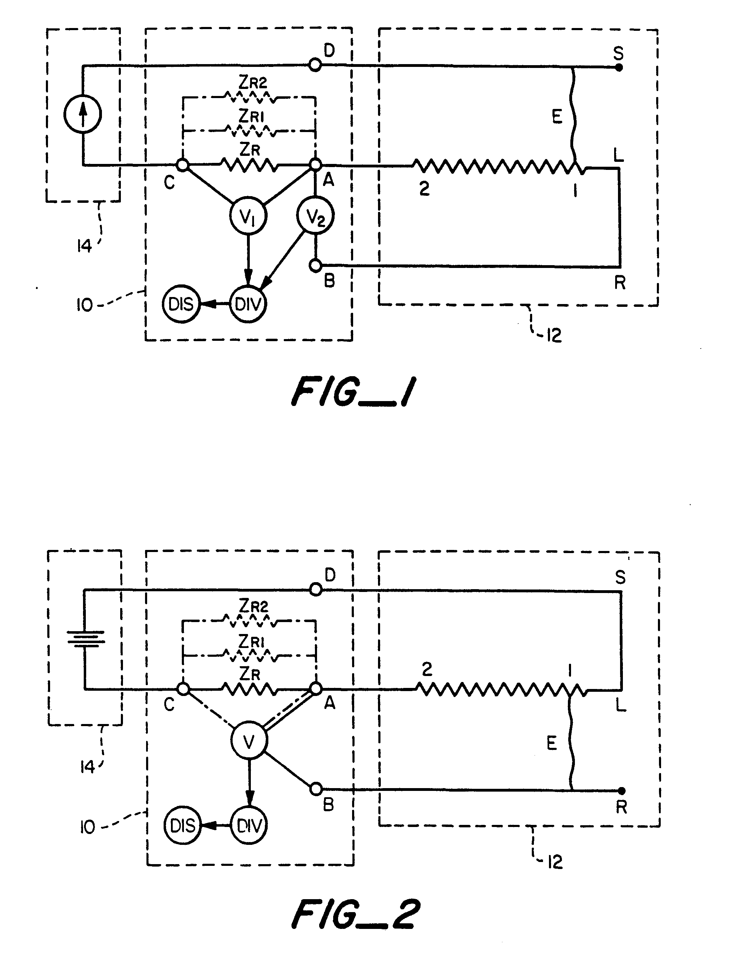

The invention is illustrated in the accompanying drawings in which Figures 1 and 2 are schematic circuit diagrams of the method and apparatus of the invention.

## DETAILED DESCRIPTION OF THE INVENTION

This invention is particularly useful in the apparatus comprising elongate locating, source and return members (hereinafter referred to as a locating assembly) over path lengths that extend a considerable distance. For inherently safe systems, a voltage of not more than 24 volts is preferred, with voltages below 10 volts being particularly preferred. This results in very low currents in very long systems, in particular currents at which controlled current sources exhibit substantial variation (up to 4%) from the "fixed current". Thus this invention is of particular value when the current is below 12 milliamps, e.g. 1 to 250 microamps. One may employ the present invention in the same general way as is disclosed in the earlier applications, but with the advantage that elongate location and second members can now have lengths substantially greater e.g. at least 2 times greater, sometimes at least 3 times greater or even at least 5 times greater than the elongate member lengths heretofore disclosed.

The invention preferably makes use of two voltage measuring devices, one measuring the first voltage drop ($V_1$) across the reference impedance, the other measuring the second voltage drop ($V_2$) down the locating member. Alternatively, a single voltage measuring device can be used together with a switch means, to measure sequentially the first and second voltage drops. The switching speed should be faster than any current size variations, so that $V_1$ and $V_2$ are measured at the same current.

The invention makes use of a divider for providing a ratio between V1 and V2, and preferably also a display, preferably digital, for displaying the ratio obtained. Conventional dividers, switching means and displays can be used for this purpose.

In a preferred embodiment, the currents transmitted between the first and second points and through the reference impedance are the same, and the divider provides a ratio of the function $Z_R\frac{V_2}{V_1}$, where $Z_R$ is the magnitude of the reference impedance, and expresses the result, in some convenient units, as the distance d to an event location, since d is proportional to the function.

By changing the size of the reference impedance, it is easy to adjust the apparatus for changes in one or more of the following variables:

(1)  the length of the locating member;

(2)  the units in which the distance to the first point is displayed;

(3)  the voltmeters employed and their various scale

0160441

MP0932

factors, bearing in mind that full scale deflection of the meter preferably corresponds to the full length of the locating member.

It is important that the reference impedance has a known, fixed value under the conditions of operation. Accordingly, the reference impedance preferably has a temperature coefficient of impedance which averages less than 0.003 per degree C over the temperature range 0° to 100°c. The reference impedance preferably has resistance and no reactance, the resistance being preferably 0.01 to 100, especially 0.1 to 10, particularly 0.5 to 2 times the resistance of the full length of the locating member. For example the resistance in ohms may be 0.5 to 1.0 times, e.g. 0.6 to 0.8 times the length of the system in meters. The devices of the invention can include two or more reference impedances each of impedance, and switching means for selecting one or more of the reference impedances so that, when the device is in use, a reference impedance of the desired size is provided.

Referring now to the drawing, Figures 1 and 2 schematically represent preferred embodiments of the present invention. A device 10 includes terminals A, B, C and D. A reference impedance $Z_R$, which may be selected from a set of reference impedances $Z_{R_1}$, $Z_{R_2}$, is connected across terminals A and C. In Figure 1, first and second conventional voltage measuring devices are connected across terminals A and C, and across terminals A and B respectively. In Figure 2, on the other hand, one voltage measuring device is employed and is connected sequentially across the terminals A and C, and A and B by way of a conventional switch means, shown functinally by way of the dotted lines. In both Figures, the

0160441
MP0932

voltage measuring devices are connected to a conventional divider (DIV), in turn connected to a conventional display (DIS).

The device 10 is connected to a location assembly 12 and a power supply 14 (a constant current supply in Figure 1 and a constant voltage supply in Figure 2). Locating member L (having an end point 2) of the location assembly 12 is connected to terminal A and second and third members (source S and return R) are connected to terminals D and B respectively. Also, one lead of the power supply 14 is connected to terminal D, while a second power supply lead is connected to terminal C. The components of the assembly 12 are differently connected in Figures 1 and 2. In Figure 1 the return and locating members are electrically connected together permanently at the far end and an event E connects the locating member and the source member at the point 1. In Figure 2, on the other hand, the source and locating members are electrically connected together permanently at the far end and an event E connects the locating member and return member at the point 1.

0160441
MPO932
EPC

## CLAIMS

1.   A method for monitoring for the occurrence of an event, and for detecting and obtaining information about the event upon its occurrence, which method comprises providing a system in which, upon occurrence of the event,

(1) electrical connection is made between an electrically conductive locating member and an electrically conductive second member;

the connection to the locating member being effective at a first point whose location is defined by at least one characteristic of the event;

the making of the connection enabling the formation of a test circuit which comprises that part of the locating member between the first point and a second point on the locating member having a known location, and in which an electrical current is transmitted between the first and second points on the locating member;

that part of the locating member between the first point and the second point being connected in series with a reference impedance which has a known impedance and the current through which has a known relationship with the current through that part of the locating member; and the current, the reference impedance and the locating member being such that, by obtaining a ratio between a first voltage drop across the reference impedance and a second voltage drop between the first and second points on the locating member, the spatial relationship between the first and second points can be determined;

(2)  the ratio of the first and second voltage drops is obtained; and

(3)  information concerning the event is obtained from the ratio in step (2).

2.  A method according to Claim 1, wherein the reference impedance has a resistance of at least 4,000 ohms, preferably 4,000 to 400,000 ohms.

3.  A method according to Claim 1 or 2, wherein the reference resistance is 0.01 to 100 times, preferably 0.1 to 10 times, especially 0.5 to 2 times, the resistance of the whole length of the locating member.

4.  A method according to any one of the preceding claims wherein said electrical current is less than 12 milliamps, preferably 1 to 250 microamps.

5.  A method according to any one of the preceding claims wherein said electrical current fluctuates within a range from +4% to -4% from a reference amplitude.

6.  Apparatus for use in a method as claimed in any one of claims 1 to 5, which apparatus comprises

0160441
MPO932
EPC

(1) an elongate electrically conductive locating member whose impedance from one end to any point on the locating member defines the spatial relationship between that end and that point;

(2) an elongate electrically conductive second member;

(3) an event-sensitive connection means which, upon occurrence of an event, effects electrical connection between the locating member and the second member, the connection being effective at a first point on the locating member which is defined by at least one characteristic of the effect;

(4) an electrically conductive third member;

(5) a reference impedance which has a known impedance and which is connected in series with said locating member;

(6) a power source which, at least when occurrence of an event causes electrical connection to be made between the locating and second members, causes a current to be transmitted (i) between the first point and a second point which is at one end of the locating member, and (ii) through said reference impedance, the size of the current transmitted through the reference impedance having a known relationship with the current transmitted between the first and second points;

(7)   a first voltage-measuring device for determining a first voltage drop across said
reference impedance,

(8)   a second voltage-measuring device for determining a second voltage drop between the
first and second points; and

(9)   a divider which provides a ratio between said
first and second voltage drops.

7.   Apparatus according to Claim 6 wherein the power source
is a constant current source whose current output fluctuates
within a range from +4% to -4% from a reference amplitude.

8.   Apparatus according to Claim 7 wherein the reference
amplitude is less than 12 milliamps, preferably 1 to 250
microamps.

9.   A device which is suitable for use in apparatus as
claimed in any one of claims 6 to 8 and which comprises

(1)   three terminals (A,B,C);

(2)   a reference impedance which has a known
impedance and which is connected between
terminals A and C;

(3)   a first voltage measuring device connected
across said reference impedance;

(4)   a second voltage measuring device connected
across terminals A and B;

0160441
MPO932
EPC

(5) a divider which provides a ratio between said first and second voltage drops;

whereby, an apparatus as claimed in Claim 6 is obtained when

(1) terminal A is connected to one end of an elongate electrically conductive locating member whose impedance from one end to any point on the locating member defines the spatial relationship between that end and that point;

(2) terminal C is connected to a power source, the power source also being connected to an elongate electrically conductive source member which is adjacent the locating member and which is connected to at least one event-sensitive connection means which, upon occurrence of an event, effects electrical connection between the locating member and the second member, the connection being effective at a first point on the locating member which is defined by at least one characteristic of the event; and

(3) terminal B is connected to an electrically conductive return member, the return member also being connected to the far end of the locating member.

FIG_1

FIG_2

**EUROPEAN SEARCH REPORT**

| | **DOCUMENTS CONSIDERED TO BE RELEVANT** | | | EP 85302559.1 |
|---|---|---|---|---|
| Category | Citation of document with indication, where appropriate, of relevant passages | | Relevant to claim | CLASSIFICATION OF THE APPLICATION (Int. Cl 4) |
| X | GB - A - 1 178 231 (POST) | | 1,6,9 | G 01 R 31/08 |
| A | * Fig. 5,6 * | | 2-5,7, 8 | |
| | ---- | | | |

**TECHNICAL FIELDS SEARCHED (Int. Cl 4)**

G 01 D 5/00

G 01 R 31/00

The present search report has been drawn up for all claims

| Place of search | Date of completion of the search | Examiner |
|---|---|---|
| VIENNA | 28-06-1985 | KUNZE |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82